# EUROPÄISCHE PATENTSCHRIFT

(11) **EP 0 924 973 B1**
(45) Veröffentlichungstag und Bekanntmachung des Hinweises auf die Patenterteilung: **02.02.2005**
(21) Anmeldenummer: 98122518.8
(22) Anmeldetag: 27.11.1998
(51) Int. Cl.: H05K 7/20, H05K 7/14

(54) **Elektrische Vorrichtung**
Electronic device
Dispositif électronique

(30) Priorität: 18.12.1997 DE 19756550
(43) Veröffentlichungstag der Anmeldung: 23.06.1999
(73) Patentinhaber: SIEMENS AKTIENGESELLSCHAFT, 80333 München (DE)
(72) Erfinder: Goldberg, Martin, 82266 Inning (DE)

(56) Entgegenhaltungen:
- DE-A- 1 803 395
- GB-A- 2 164 499
- US-A- 4 771 365
- US-A- 4 974 317

## Beschreibung

Die vorliegende Erfindung betrifft eine elektrische Vorrichtung mit einem Gehäuse und darin angeordneten voneinander beabstandeten elektrischen Baugruppen.

Bislang sind an dem Gehäuse Kühlbleche befestigt, die zur Ableitung der von den Baugruppen entwickelten Wärme dienen. Der Wärmeleitweg von dem einzelnen Bauelement einer Baugruppe über die Baugruppenplatine zum Gehäuse ist lang, was zur Folge hat, daß die Abführung der Wärme unzureichend ist. Ferner sind zusätzliche elektromagnetische Schirmeinrichtungen vorgesehen, um die elektrischen Baugruppen HF-technisch voneinander zu isolieren. Es ist ein durch Umluft gespeister Innenkreislauf und Außenluftkreislauf vorhanden. Die Wärme aus dem Innenkreislauf wird über einen Wärmetauscher an die Außenluft abgegeben.

Aus US 4,771,365 ist ein passiv gekühltes "electronic chassis" bekannt. Dabei ist ein erstes "board" über ein erstes "insulator sheet" und ein zweites "board" über ein zweites "insulator sheet" an einem gemeinsamen, aus Aluminium gefertigten "core member" befestigt. Das "core member" ist als Träger der beiden "boards" zwischen einem ersten "housing" und einem zweiten "housing" angeordnet.

Aufgabe der vorliegenden Erfindung ist es, die gattungsgemäße Vorrichtung derart weiterzuentwickeln, daß eine verbesserte Wärmeableitung unter Angabe möglichst kurzer Wärmeleitstrecken verwirklicht wird.

Dies wird erfindungsgemäß erreicht durch eine elektrische Vorrichtung mit einem Gehäuse und darin angeordneten voneinander beabstandeten elektrischen Baugruppen, wobei je zwischen zwei benachbarten elektrischen Baugruppen eine Kühleinrichtung angeordnet ist, die ein Teil des Gehäuses ist (Sandwich-Bauweise).

Dadurch wird jede elektrische Baugruppe in einer durch die benachbarten Kühleinrichtungen in Verbindung mit dem Gehäuse gebildeten Kammer wärmetechnisch isoliert und gekühlt. Die benachbarten Kühleinrichtungen nehmen die Wärme auf und führen sie über das Gehäuse ab. Ein möglichst kurzer Weg vom Bauteil der einzelnen Baugruppe nach außen ist gewährleistet. Ferner ist ein hermetisch dichter Aufbau angegeben, da die Kühleinrichtungen spaltlos zu einem Gehäuse verbunden sind. Aufgrund der beliebigen Aneinanderreihung von Baugruppen und Kühleinrichtungen ist ein flexibler Aufbau ermöglicht.

Bei der erfindungsgemäßen elektrischen Vorrichtung ist daher besonders vorteilhaft, daß die Kühleinrichtungen gleichzeitig die HF-Schirmung übernehmen, und daß dabei nur ein Außenluftkreislauf vorhanden ist. In diesem Zusammenhang ist es ferner wichtig, daß alle Kühleinrichtungen einen guten thermischen Kontakt haben.

Es ist bevorzugt, daß die Kühleinrichtungen plattenförmig ausgebildet und jeweils im wesentlichen parallel zu den benachbarten Baugruppen angeordnet sind. Dadurch wird die Verlustwärme großflächig aufgenommen und abgeführt. Ferner ergeben sich fertigungstechnische Vorteile aufgrund der Parallelanordnung.

Die Kühleinrichtungen sind aus einem Material gebildet, das zur HF-Abschirmung geeignet ist. Dadurch wirken die Kühleinrichtungen gleichzeitig als HF-Schirmeinrichtungen und bilden HF-Schirmkästchen für jede Baugruppe.

Es ist bevorzugt, daß einzelne Elemente einer Baugruppe mit der benachbarten Kühleinrichtung durch lösbare Wärmeleitelemente verbunden sind. Derartige Wärmeleitelemente können beispielsweise Wärmeleitmatten oder Wärmeleitfedern sein. Aufgrund der Wärmeleitelemente, welche das Bauteil mit der Kühleinrichtung verbinden, ist der Wärmewiderstand von Bauteil zu Kühleinrichtung gering und die Bauteiltemperatur ebenfalls gering.

Es ist ferner bevorzugt, daß einzelne Kühleinrichtungen auf einer Außenfläche mit mehreren Vertiefungen gebildet sind, die durch Stege voneinander getrennt sind. Die Vertiefungen bilden zusätzliche Kästchen, die HF-technisch isolieren und eine zusätzliche Kühlwirkung aufgrund der vergrößerten Oberfläche der Kühleinrichtung entfalten. Durch Ausbildung mehrerer Vertiefungen, die spezielle Bauelemente einer Baugruppe einfassen, wird die Wärmeabführung gesteigert.

Es sind bevorzugt Kühleinrichtungen vorgesehen, die mit einer von den Bauelementen einer Gruppe abgewandten Außenseite einer Baugruppe im wesentlichen ganzflächig in Kontakt sind. Diese Kühleinrichtungen kühlen die Baugruppen unmittelbar auf ihrer Rückseite.

Es ist ferner bevorzugt, daß hintereinander abwechselnd angeordnete Baugruppen und Kühleinrichtungen durch eine oder mehere Schraube(n) verbunden sind. Dadurch wird die Halterung verbessert und eine zusätzliche wärmetechnische Verbindung bereitgestellt.

Es ist schließlich bevorzugt, daß bei der elektrische Vorrichtung Kühlung, HF-Schirmung und hermetisch dichtes Gehäuse in Einem verwirklicht ist.

Ausführungsbeispiele der Erfindung ergeben sich aus der nachfolgenden Beschreibung in Verbindung mit der Zeichnung.
- Figur 1: zeigt eine perspektivische Ansicht einer Ausführungsform einer elektrischen Vorrichtung gemäß der Erfindung.
- Figur 2: zeigt einen Querschnitt durch eine weitere Ausführungsform einer elektrischen Vorrichtung gemäß der Erfindung.

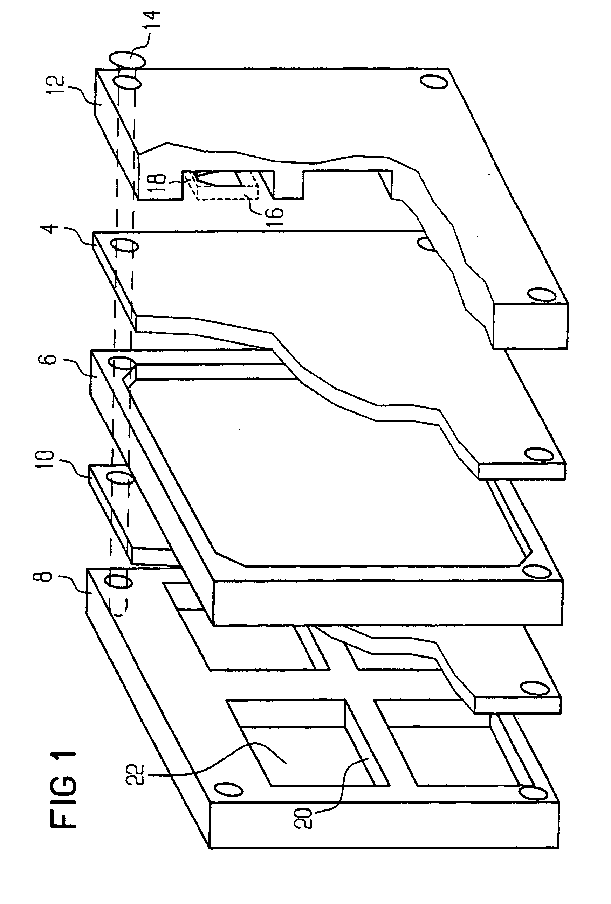

In der Figur 1 sind perspektivisch dargestellt eine vordere Kühleinrichtung 12, hinter der eine zu kühlende Baugruppe 4 angeordnet ist. Hinter der Baugruppe 4 ist eine weitere Kühleinrichtung 6 angeordnet, der wiederum eine Baugruppe 10 folgt. Abschließend ist eine Kühleinrichtung 8 angeordnet. Die Kühleinrichtung 8 ist an ihrer der Baugruppe 10 zugewandten Vorderseite mit vier im wesentlichen quadratischen Vertiefungen 22 versehen, die zur Aufnahme von prominenten Bauelementen der Baugruppe 10 dienen. Die Vertiefungen 22 sind durch Stege 20 voneinander getrennt.

Einen ähnlichen Aufbau hat die Kühleinrichtung 12, die in Figur 1 von ihrer Rückseite her gezeigt ist. Schematisch ist ein Bauelement 16 gezeigt, das bei der Montage der Vorrichtung in eine Vertiefung der Kühleinrichtung 12 eingreift. Zur Verstärkung der Wärmeableitung ist ein Wärmeleitelement 18 in Form einer Wärmeleitfeder vorgesehen, das das Bauelement federnd mit dem Boden einer Vertiefung der Kühleinrichtung 12 verbindet. Anstelle von Wärmeleitfedern ist auch der Einsatz von Wärmeleitmatten vorgesehen.

In den Kühleinrichtungen 12, 6 und 8 sowie in den Baugruppen 4, 10 sind randseitig Durchgangsöffnungen gebildet, die zur Durchführung einer beispielhaft gezeigten Schraube 14 bzw. eines entsprechenden Bolzens dienen. Dadurch wird die Halterung verbessert und ein zusätzlicher Wärmeleitkontakt vorgesehen. Es sind auch Durchgangsöffnungen für Kabel, Stecker und dergleichen vorgesehen.

Kühleinrichtungen und Baugruppen sind jeweils abwechselnd hintereinander angeordnet, um jede Baugruppe einzeln in Kontakt mit dem Gehäuse hermetisch abzuriegeln und getrennt von den anderen Baugruppen zu kühlen. Ferner sind die Kühleinrichtungen 8, 6, 12 aus einem HF-technischen Abschirmmaterial gebildet, so daß jede Baugruppe gegenüber den anderen Baugruppen auch HF-abgeschirmt ist. Die plattenförmigen Kühleinrichtungen 6, 8, 12 sind spaltlos mit dem Gehäuse 2 verbunden bzw. bilden dessen Außenwand.

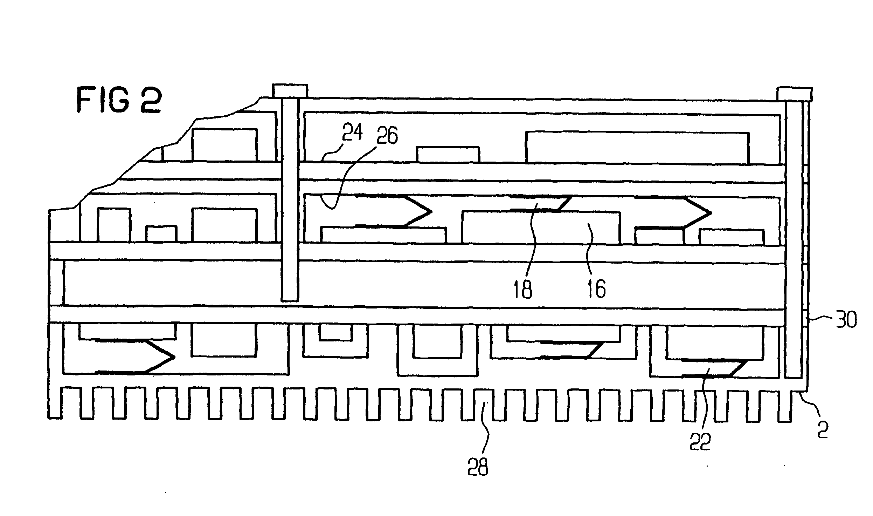

In Figur 2 ist ein Querschnitt durch eine weitere Ausführungsform einer Vorrichtung gemäß der Erfindung gezeigt. Das Gehäuse 2 faßt die hintereinander abwechselnd angeordneten Kühleinrichtungen und Baugruppen ein. An den Baugruppen befinden sich prominente Bauelemente 16, die in den Zwischenraum zwischen Bauelement und Kühleinrichtung, hier beispielsweise 26, vorspringen.

Wärmeleitelemente 18 verbinden das Bauelement 16 mit der Kühleinrichtung 26. Im zusammengebauten Zustand ist eine hinter der Kühleinrichtung 26 angeordnete Baugruppe 24 in ganzflächigem Kontakt mit dieser. Dadurch wird die Wärmeabfuhrleistung gesteigert.

Wie in Figur 2 zu sehen ist, bildet die Kühleinrichtung 28 gleichzeitig eine Außenwand des Gehäuses 2. Die Vertiefungen 22 sind so gebildet, daß entsprechende prominente Bauteile der benachbarten Baugruppe 30 überdeckt und eingefaßt werden. Die Wärmeableitung ist dadurch und durch zusätzliche Wärmeleitelemente zwischen Bauelement und Kühleinrichtung verbessert.

## Patentansprüche

1. Elektrische Vorrichtung mit einem Gehäuse (2) und darin angeordneten, voneinander beabstandeten und wenigstens je ein Bauelement (16) enthaltenden elektrischen Baugruppen (4, 10, 24),
**dadurch gekennzeichnet,**
**dass** je zwischen zwei benachbarten elektrischen Baugruppen (4, 10) eine Kühleinrichtung (6, 8, 12, 26) angeordnet ist, die einen Teil des Gehäuses (2) bildet, wobei die jeweilige elektrische Baugruppe (4, 10) mit einer durch die benachbarte Kühleinrichtung (6, 8, 12) gebildeten Kammer eine hermetisch abgeschlossene Einheit zur Kühlung und elektromagnetischen Abschirmung der elektrischen Baugruppe (4, 10) bildet.

2. Elektrische Vorrichtung nach Anspruch 1,
**dadurch gekennzeichnet,**
**dass** die Kühleinrichtungen (6, 8, 12) plattenförmig ausgebildet und jeweils parallel zu benachbarten Baugruppen (4, 10) angeordnet sind.

3. Elektrische Vorrichtung nach Anspruch 1 oder 2,
**dadurch gekennzeichnet,**
**dass** die Kühleinrichtungen (6, 8, 12, 26) aus einem Material gebildet sind, das zu einer HF-Abschirmung geeignet ist.

4. Elektrische Vorrichtung nach einem der vorhergehenden Ansprüche, **dadurch gekennzeichne t,** dass einzelne Bauelemente (16) einer Baugruppe (4, 10, 24) mit der benachbarten Kühleinrichtung (12) durch lösbare Wärmeleitelemente (18) verbunden sind.

5. Elektrische Vorrichtung nach einem der vorhergehenden Ansprüche, **dadurch gekennzeichnet, dass** einzelne Kühleinrichtungen (8, 12) auf einer den Bauelementen (16) der Baugruppe (4, 10) zugewandten Seite mit mehreren Vertiefungen (22) versehen sind, die durch Stege (20) voneinander getrennt sind.

6. Elektrische Vorrichtung nach einem der vorhergehenden Ansprüche, **dadurch gekennzeichnet, dass** Kühleinrichtungen (26) vorgesehen sind, die mit einer von den Bauelementen einer Baugruppe abgewandten Außenseite einer Baugruppe (24) ganzflächig in Kontakt sind.

7. Elektrische Vorrichtung nach einem der vorhergehenden Ansprüche, **dadurch gekennzeichnet, dass** hintereinander abwechselnd angeordnete Baugruppen (4, 10) und Kühleinrichtungen (12, 6, 8) durch eine Schraube (14) miteinander verbunden sind.

## Claims

1. Electrical device having a housing (2) and electrical modules (4, 10, 24) arranged therein, distanced from one another, each containing at least one component (16),
**characterised in that**
a cooling system (6, 8, 12, 26) is arranged between each two adjacent electrical modules (4, 10), which forms part of the housing (2), wherein, by means of a chamber formed using the adjacent cooling system, the respective electrical module (4, 10) forms an air tight unit for cooling and electromagnetic shielding of the electrical module (4, 10).

2. Electrical device according to Claim 1
**characterised in that**
the cooling systems (6, 8, 12) are embodied as plates and are each arranged parallel to adjacent modules (4, 10).

3. Electrical device according to Claim 1 or 2
**characterised in that**
the cooling systems (6, 8, 12, 26) are fashioned from a material which is suitable for a high frequency shielding.

4. Electrical device according to one of the preceding Claims
**characterised in that**
individual components (16) of a module (4, 10, 24) are connected to the adjacent cooling system (12) by means of soluble heat conductive elements (18).

5. Electrical device according to one of the preceding Claims
**characterised in that**
individual cooling systems (8, 12) are provided on a side facing the components (16) of the modules (4, 10) with a plurality of indentations (22) which are separated from one another by means of bars (20).

6. Electrical device according to one of the preceding Claims
**characterised in that**
cooling systems (26) are provided which are in contact over their entire surface with an external side of a module (24) facing away from the components of a module.

7. Electrical device according to one of the preceding Claims
**characterised in that**
the modules (4, 10) and cooling systems (12, 6, 8) are arranged alternately one behind another and connected by means of a screw (14).

## Revendications

1. Dispositif électrique comprenant un boîtier (2) et des ensembles (4, 10, 24) électriques disposés à l'intérieur, espacés les uns des autres et contenant chacun au moins un composant (16),
**caractérisé en ce que**
entre deux ensembles (4, 10) électriques voisins est disposé à chaque fois un appareil réfrigérant (6, 8, 12, 26) qui forme une partie du boîtier (2), l'ensemble (4, 10) électrique respectif formant avec une chambre formée par l'appareil réfrigérant (6, 8, 12) voisin une unité hermétiquement fermée pour le refroidissement et le blindage électromagnétique de l'ensemble (4, 10) électrique.

2. Dispositif électrique selon la revendication 1,
**caractérisé en ce que**
les appareils réfrigérants (6, 8, 12) sont conçus en forme de plaques et sont disposés respectivement parallèlement à des ensembles (4, 10) voisins.

3. Dispositif électrique selon la revendication 1 ou 2,
**caractérisé en ce que**
les appareils réfrigérants (6, 8, 12, 26) sont formés dans un matériau qui convient pour un blindage HF.

4. Dispositif électrique selon l'une quelconque des revendications précédentes,
**caractérisé en que**
des composants (16) individuels d'un ensemble (4, 10, 24) sont reliés à l'appareil réfrigérant (12) voisin par des éléments conducteurs de chaleur (18) amovibles.

5. Dispositif électrique selon l'une quelconque des revendications précédentes,
**caractérisé en que**
des appareils réfrigérants (8, 12) individuels sont pourvus sur un côté, tourné vers les composants (16) de l'ensemble (4, 10), de plusieurs cavités (22) qui sont séparés par des barrettes (20).

6. Dispositif électrique selon l'une quelconque des revendications précédentes,
**caractérisé en que**
des appareils réfrigérants (26) sont prévus, qui sont en contact sur toute la surface avec un côté extérieur, opposé aux composants d'un ensemble, d'un ensemble (24).

7. Dispositif électrique selon l'une quelconque des revendications précédentes,
**caractérisé en que**
des ensembles (4, 10) et des appareils réfrigérants (12, 6, 8), disposés alternativement les uns derrière les autres, sont reliés entre eux par une vis (14).
